# EUROPEAN PATENT SPECIFICATION

(11) **EP 1 886 544 B1**
(45) Date of publication and mention of the grant of the patent: **23.03.2011**
(21) Application number: 06755395.8
(22) Date of filing: 02.06.2006
(51) Int. Cl.: H05K 3/28, A41D 1/00, A41D 13/12

(54) **METHOD AND ARRANGEMENT FOR PROTECTING SENSITIVE COMPONENTS BY TEXTILE AND PRODUCT INCLUDING SAID ARRANGEMENT**
VERFAHREN UND ANORDNUNG ZUM SCHUTZ EMPFINDLICHER KOMPONENTEN DURCH TEXTILIEN UND PRODUKT MIT DER ANORDNUNG
PROCEDE ET DISPOSITIF DE PROTECTION DE COMPOSANTS SENSIBLES AU MOYEN D'UN TEXTILE, ET PRODUIT COMPRENANT CE DISPOSITIF

(30) Priority: 03.06.2005 FI 20050593
(43) Date of publication of application: 13.02.2008
(73) Proprietor: Clothing Plus Oy, 38701 Kankaanpää (FI)
(72) Inventor: VANHALA, Jukka, FI-33960 Pirkkala (FI); TASANEN, Mikko, FI-33820 Tampere (FI); REHO, Akseli, FI-38700 Kankaanpää (FI); VÄLIMÄKI, Elina, FI-33210 Tampere (FI)
(74) Representative: Brax, Matti Juhani
(86) International application number: PCT/FI2006/000173
(87) International publication number: WO 2006/128957

(56) References cited:
- EP-A- 1 559 335
- WO-A1-00/16493
- WO-A1-2005/124015
- US-A- 4 774 434
- US-A- 4 876 724
- US-A1- 2005 029 680

## Description

The invention relates to a method and arrangement for protecting sensitive components by means of textile, and to a product including said arrangement. In particular, the invention relates to protecting electronic components integrated in textile accessories and remote controls against external factors, which textile accessories can, when necessary, be connected to a garment for instance by sewing.

There is currently available a large number of various intelligent garments containing electronic components, such as sensors, antennae, batteries, press keys, LED lights, transmitters, receivers, photocells, switches, amplifiers, connectors and even processors, as well as cable systems connecting these. In part, this sets high requirements for textile research and development to produce products that are more comfortable and more easily designed. At present, textile has become an important practical solution as a casing for electronic products. Textile gives an essential extra potential for a product especially as regards the feel and appearance of it.

From the prior art, there are known some attempts to protect an electronic component by textile. For example in the publication WO 03/077510 A1, there is described a cover for a mobile phone. This brings new dimensions in the casing branch, from the point of view of design and personal approach. According to said publication, usage comfort and the feel of the product have been improved by textile coating. However, the invention according to said publication does not improve the resilience or waterproofness of the product. The publication mentions a plastic object or other injection molded object to which textile can be connected.

Moreover, the publication US 2004/0115430 A1 describes a solution for installing electronics directly inside textile fibers. From the point of view of technical implementation, this is, however, very demanding and time-consuming, and consequently also very expensive to be realized with current technology. There also is generally known the use of textile structures for instance in the aircraft industry, for protecting cables from external disturbance. The light weight of textiles is particularly appreciated in the aircraft industry. In these solutions, the textile structures are braided structures, and hence they do not improve waterproofness.

EP 1559335 discloses an arrangement in which a heart rate sensor device is placed in the textile pocket (116) which has an open end for reception of the sensor device and which has holes (144) through which the electrodes of the sensor device are connected to the skin.

However, there are some drawbacks in the prior art arrangements. Known textile protection solutions are typically rigid and difficult to shape. Moreover, many of them are demanding as well as slow and expensive to manufacture. Often the prior art solutions also are esthetically unsatisfactory and cumbersome to use and wear. In addition, an outer cover made of textile brings new challenges to the product, such as how to keep it clean. In addition, a textile cover often is insufficient against moisture and impacts, for instance. In order to obtain a textile encased product that can be used without worries, it must be provided with excellent protection. From the point of view of cleaning the product, it is essential to achieve adequate washability features. As regards a casual and relaxed use of the product, also a sufficient waterproofness and mechanical protection must be achieved.

The object of the invention is to provide a solution where the above described drawbacks connected to the prior art can be alleviated. The invention attempts to solve the problem how textile can be used for protecting electronic components against water, mechanical strain and other external factors, such as electromagnetic interference, so that the textile product containing the component is at the same time resilient and pleasant to wear, and that the product also is esthetically acceptable in appearance and easy to keep clean. Another object of the invention is to enable a fast, easy and economical production of the described textile product, even serial production.

The objects of the invention for at least partly protecting a component by textile are achieved by means of an arrangement according to claim 1 and a method according to claim 11, as well as by means of a product according to claim 14. In addition, the objects of the invention can be achieved by means of the additional features enlisted in the dependent claims.

The arrangement according to the invention for at least partly protecting a component by textile is characterized by what is set forth in claim 1. The method according to the invention for at least partly protecting a component by textile is characterized by what is set forth in claim 11. The product according to the invention is characterized by what is set forth in claim 14. In addition, the dependent claims describe preferred embodiments of the invention.

Among others, the present application uses the following concepts:
- A "component", particularly an electronic component, is for example a textile cable, textile sensor, textile press key, textile antenna, a power source such as an accumulator or battery, a display, LED light, processor, transmitter, receiver, photocell, amplifier and/or a connector.
- A "cover structure" is a protective structure arranged around the component to be protected. The cover structure can surround the component either completely or at least partly. According to the invention, around the component there can be arranged one or several cover structures, which cover structures advantageously differ in features, such as hardness and resilience as well as other protective qualities. According to the invention, at least one cover structure is a permanently closed cover structure that can be achieved for instance in the manufacturing process by encapsulating the cover structure, so that neither the user nor even maintenance can open said cover structure without essentially breaking it.
- A "textile" can be a cloth, a woven or knitted fabric or some other corresponding textile-like structure, of which at least the first cover structure according to the invention can be manufactured. In this document, textile can also mean leather or other material used in textile industry and known by those skilled in the art.
- A "product" can be any product containing the textile cover structure according to the invention, most advantageously a product that can be worn by the user. Said product can be for example a garment, such as a coat, shirt, hat, trousers, shoe, sock, glove, bag or knapsack, or some other textile structure, such as a textile laminated accessory, remote control, clock, data processing device or an element measuring the user's bodily functions or parameters.

The invention relates to protecting sensitive components by textile against external factors, such as moisture, physical strain, impacts and/or electromagnetic interference. For example sensitive components, such as electronics, can be encased and protected by laminating the textiles together. By means of laminated textile surfaces, there is achieved a sufficient moisture insulation and insulation against electrical interference.

According to a first embodiment of the invention, a component is surrounded by a permanently closed first cover structure that is made of textile, which cover structure is most advantageously realized by laminating. The cover structure can also be achieved by adhesion, welding (ultrasonic or laser welding), sewing, taping or vulcanizing. Said first textile cover structure protects electronics particularly well against moisture. The textile cover structure also protects electronics against mechanical strain. In addition, the textile cover structure can be arranged to protect electronics against electromagnetic interference, for example by adding a suitable amount of metallic fibers in the textile structures.

When necessary, additional protective structures can be added inside the textile cover structure for protecting most sensitive components. According to another embodiment of the invention, around the component to be protected there is arranged a hard, essentially nonbending second cover structure. Most advantageously said second cover structure is a hard plastic casing that provides a good mechanical protection for the electronic component to be protected, and at the same time enables cable clamping. Most advantageously said second cover structure is arranged between said first cover structure and said component. Said second cover structure can also be for instance a reinforcement cast on top of a circuit board containing said component.

According to a third embodiment of the invention, around said second cover structure there is arranged a third cover structure that is essentially softer than the second cover structure. Said third cover structure protects the component to be protected against impacts and pads the component to be protected and/or the second cover structure to be softer, thus protecting the user, so that the component and/or the second, essentially hard cover structure does not feel hard, inelastic and unpleasant for the user. Said third cover structure can be arranged in between the first and second cover structures. The third cover structure can be manufactured for example of some gel-like material, such as silicone.

According to a fourth embodiment of the invention, said third soft cover structure is arranged around the component to be protected, so that said third cover structure is placed between said first cover structure and said component. This embodiment does not at all include said second cover structure.

According to the invention, the above mentioned cover structures can be mechanically attached. The outermost textile layer can be laminated to the inner protective structures.

It is pointed out that press keys can be used through the textile cover, and several sensors function through the textile protection. However, a "window" to the exterior must be provided for some of the components placed inside the protection. An aperture can be made in the outermost protective cover, among others for sensors, displays and connectors.

According to the invention, said second cover structure is essentially impact resistant and/or impermeable to light, pressure and/or moisture. Moreover, according to the invention said first and/or third cover structure is essentially waterproof, resilient and/or softer than the second cover structure. In addition, the first, second and/or third cover structure can be arranged to protect the component also against external electromagnetic interference. Likewise, the second cover structure can be essentially waterproof and/or resilient.

In comparison with the prior art arrangements, indisputable advantages are gained by the present invention. By means of an arrangement according to the invention, sensitive components integrated inside textile structures typically worn by the user can be protected against external mechanical strain, still maintaining in the textile-structured product, such as a garment, its resilience and softness as well as its comfort when using the product. Moreover, the arrangement according to the invention provides the components a protection against moisture, pressure and light, and still maintains the feature that the product in which the component is integrated is easy to keep clean.

In particular with a permanently closed cover structure according to the invention, there also is achieved waterproofness, which is not nearly as reliably and easily realized in case the cover structure is closed so that it can be reopened. Moreover, a permanently closed cover structure is more economical to manufacture for example in serial production than one that is supposed to be opened. In addition, a permanently closed cover structure offers a solution that is more secure in operation for protecting components than one that is meant to be opened.

In the specification below, preferred embodiments of the invention are described in more detail with reference to the appended drawings, where
- Figure 1: illustrates an exemplary arrangement for protecting a component according to a preferred embodiment of the present invention,
- Figure 2: illustrates an exemplary arrangement for protecting several different types of components according to a preferred embodiment of the present invention, and
- Figures 3a-3b: illustrates a few exemplary products provided with an arrangement according to Figure 1 or 2 for protecting a component according to a preferred embodiment of the present invention.

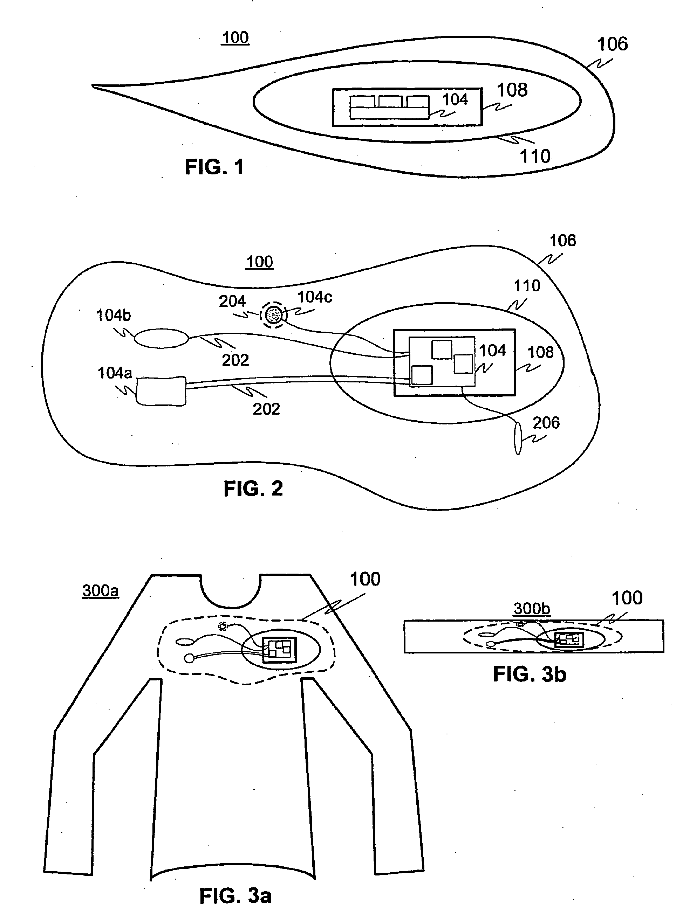

Figure 1 illustrates an exemplary arrangement 100 for protecting a component 104 according to a preferred embodiment of the present invention, where the component 104 is surrounded by textile, most advantageously by a permanently closed first cover structure 106, which cover structure is most advantageously realized by laminating textile layers. The cover structure 106 can also be realized by means of adhesion, welding, taping, vulcanizing or sewing. Said first textile cover structure 106 protects the component 104 particularly well against moisture. The textile cover structure 106 also protects the component against mechanical strain. Moreover, the textile cover structure 106 can be arranged to protect the component against electromagnetic interference, for instance by adding a suitable amount of metallic fibers in the textile structures.

When necessary, inside the textile cover structure 106, there can be added conventional protective structures for protecting the most sensitive components 104. In addition to the first cover structure 106, around the component 104 to be protected there can be arranged a hard, essentially nonbending second cover structure 108. Preferably said second cover structure 108 is a hard plastic casing 108 that provides a good mechanical protection for the component to be protected, most typically and electronic component, and enables cable clamping for example for the cables connected to said component (illustrated in connection with Figure 2). Preferably said second cover structure 108 is arranged between said first cover structure 106 and said component 104.

Moreover, around said second cover structure 108, there can also be arranged a third cover structure 110 that is essentially softer than said second cover structure 108. Said third cover structure 110 protects the component 104 to be protected against impacts and pads the component 104 to be protected and/or the second cover structure 108 to be softer, thus protecting the user, so that the component 104 and/or the second, essentially hard cover structure 108 does not feel hard, inelastic or unpleasant for the user. Most advantageously said third cover structure 110 is arranged in between the first and second cover structures 106, 108.

Figure 2 illustrates an exemplary arrangement 100 for protecting several different types of components 104, 104a, 104b, 104c according to a preferred embodiment of the present invention. In figure 2, the component 104 is most sensitive of all, including for example a processor or the like, in which case it is protected by all three different types of cover structures 106, 108, 110. The components 104a, 104b represent some less sensitive components that do not need extra protection and that can be used or that function through the textile cover structure 106. This kind of component 104a, 104b is for example an antenna, a transmitter/receiver, a textile press key, a sensor or a switch. Typically also cables 202 that endure bending and even stretching can be placed in the arrangement 100 without extra protection. According to the invention, the cables 202 can, however, be protected against external interference and moisture. The invention is still not restricted to use the above described cables only, but the cables can be either elastic or inelastic.

Moreover, in an embodiment the arrangement 100 according to the invention includes a switching element, such as and inductive or capacitive element 206, whereby energy can be transferred through at least one cover structure 106, 108, 110 without a galvanic connection. The switching element 206 can supply the electric current directly to the components 104, or as an alternative, a rechargeable power source, such as an accumulator, can be charged thereby.

It is pointed out that even if press keys can be used through the textile cover structure 106, and several sensors function through the textile protection, part of the components 104c placed inside the cover structure must still be offered a "window" to the exterior. An aperture 204 can be made in the outermost, i.e. the first cover structure 106 for some sensors, displays, connectors and switches, for example.

Figure 3a illustrates an exemplary product 300a, provided with an arrangement according to Figure 1 or 2 for protecting a component according to a preferred embodiment of the present invention. The product 300a is a garment that can be worn by the user. In addition, Figure 3b illustrates another exemplary product 300b, provided with an arrangement according to Figure 1 or 2 for protecting a component according to a preferred embodiment of the present invention. The product 300b is preferably a textile laminated accessory, such as an element measuring the bodily functions or parameters of the user.

In the specification above, we have described only a few preferred embodiments of the invention. The principle according to the invention can naturally be modified within the scope defined in the appended claims, for instance as regards practical details of the application and its targets of usage. According to the principles of the invention, it also is possible to protect components integrated for instance in furniture or the like, for example sensors embedded in chairs or sofas, or systems comprising other electronic components. Moreover, when compiling a textile cover structure, there can be used, among others, silicone, polymer, elastomer or rubber.

## Claims

1. An arrangement (100) for protecting a component (104, 104a, 104b, 104c) at least partly by textile, in which arrangement the component is at least partly surrounded by a first cover structure (106), where around the component (104) to be protected, between the first cover structure (106) and said component, there is at least partly arranged an additional hard, essentially nonbending second cover structure (108), wherein at least part of the protected component and/or at least one other component (104a, 104b, 104c), such as particularly a textile component and/or a flexible component, is arranged at least partly outside said second cover structure, **characterized in that** the first cover structure is permanently closed and made of textile which cover structure is realized by laminating, adhesion, welding, taping and/or vulcanizing.

2. An arrangement according to claim 1, where around the component (104) to be protected, between the first cover structure (106) and said component, there also is at least partly arranged a soft third cover structure (110).

3. An arrangement according to claim 1, where around said second cover structure (108), in between the first (106) and second (108) cover structures, there also is at least partly arranged a third cover structure (110) that is essentially softer than said second cover structure (108).

4. An arrangement according to claim 1, where said second cover structure (108) is a reinforcement cast on top of a circuit board.

5. An arrangement according to any of the preceding claims, where the component (104, 104a, 104b, 104c) to be protected is an electronic component, such as a textile cable, textile sensor, textile press key, textile antenna, power source, display, LED light, processor, transmitter, receiver, photocell, amplifier and/or a connector.

6. An arrangement according to claim 1, where the cover structure (106) is provided with at least one aperture (204) for leading through a user interface of the component to be protected, such as a press key or the like (104c), and/or for leading through some other element connected to the component and/or included in the component.

7. An arrangement according to claim 1, where said second cover structure (108) is essentially impact resistant and/or impermeable to light, pressure and/or moisture.

8. An arrangement according to claim 1, 2 or 3, where said first and/or third cover structure (106, 110) is essentially waterproof, resilient and/or softer than the second cover structure (108).

9. An arrangement according to claim 1, 2 or 3, where the first, second and/or third cover structure (106, 108, 110) are arranged to protect said component also against electromagnetic interference.

10. An arrangement according to any of the preceding claims, where said arrangement is provided with a switching element (206), such as an inductive or capacitive element, for transferring energy wirelessly through at least one cover structure (106, 108, 110).

11. A method for protecting a component (104, 104a, 104b, 104c) by means of textile, in which method the component is at least partly surrounded by a first cover structure (106), where around the component (104) to be protected, in between the first cover structure (106) and said component, there also is arranged a hard, essentially nonbending second cover structure (108), wherein at least part of the protected component and/or at least one other component (104a, 104b, 104c), such as particularly a textile component and/or a flexible component, is arranged at least partly outside said second cover structure, **characterized in that** the first cover structure is permanently closed and made of textile which cover structure is realized by laminating, adhesion, taping and/or vulcanizing.

12. A method according to claim 11, where around the component (104) to be protected, in between the first cover structure (106) and said component, there also is arranged a soft third cover structure (110).

13. A method according to claim 11, where around said second cover structure (108), in between the first (106) and second (108) cover structures, there is at least partly arranged a third cover structure (110) that is essentially softer than said second cover structure (108).

14. A product (300a, 300b), **characterized in that** it is provided with an arrangement (100) according to any of the claims 1 - 10.

15. A product according to claim 14, where said product (300a) is garment, such as a coat, shirt, hat, pair of trousers, shoe, sock, glove, bag or a knapsack, or where the product (300b) is an accessory, remote control, clock, data processing device or an element measuring the bodily functions or parameters of the user.

## Patentansprüche

1. Anordnung (100) zum Schützen einer Komponente (104, 104a, 104b, 104c) mindestens teilweise durch einen Textilstoff, wobei in dieser Anordnung die Komponente mindestens teilweise von einer ersten Abdeckungsstruktur (106) umgeben ist, wobei um die zu schützende Komponente (104) herum, zwischen der ersten Abdeckungsstruktur (106) und der Komponente, mindestens teilweise eine zusätzliche harte, im Wesentlichen nicht biegbare zweite Abdeckungsstruktur (108) angeordnet ist, wobei mindestens ein Teil der geschützten Komponente und/oder mindestens eine weitere Komponente (104a, 104b, 104c), wie zum Beispiel insbesondere eine Textilkomponente und/oder eine flexible Komponente, mindestens teilweise außerhalb der zweiten Abdeckungsstruktur angeordnet ist, **dadurch gekennzeichnet, dass** die erste Abdeckungsstruktur permanent geschlossen ist und aus Textilstoff besteht, wobei die Abdeckungsstruktur durch Laminieren, Kleben mittels Klebstoff, Schweißen, Kleben mittels Klebeband und/oder Vulkanisieren hergestellt wird.

2. Anordnung nach Anspruch 1, wobei um die zu schützende Komponente (104) herum, zwischen der ersten Abdeckungsstruktur (106) und der Komponente, mindestens teilweise auch eine weiche dritte Abdeckungsstruktur (110) angeordnet ist.

3. Anordnung nach Anspruch 1, wobei um die zweite Abdeckungsstruktur (108) herum, zwischen der ersten (106) und der zweiten (108) Abdeckungsstruktur, mindestens teilweise auch ein dritte Abdeckungsstruktur (110) angeordnet ist, die wesentlich weicher als die zweite Abdeckungsstruktur (108) ist.

4. Anordnung nach Anspruch 1, wobei die zweite Abdeckungsstruktur (108) eine auf eine Leiterplatte aufgegossene Verstärkung ist.

5. Anordnung nach einem der vorhergehenden Ansprüche, wobei die zu schützende Komponente (104, 104a, 104b, 104c) eine elektronische Komponente, wie zum Beispiel ein Textilkabel, ein Textilsensor, ein Textildrucktaster, eine Textilantenne, eine Stromquelle, eine Anzeige, eine Leuchtdiode, ein Prozessor, ein Sender, ein Empfänger, eine Photozelle, ein Verstärker und/oder ein Anschlussteil sein kann.

6. Anordnung nach Anspruch 1, wobei die Abdeckungsstruktur (106) mit mindestens einer Öffnung (204) versehen ist, um durch sie eine Benutzerschnittstelle der zu schützenden Komponente, wie zum Beispiel einen Drucktaster oder dergleichen (104c), hindurch zu führen und/oder um durch sie ein anderes Element, das mit der Komponente verbunden und/oder in der Komponente enthalten ist, hindurch zu führen.

7. Anordnung nach Anspruch 1, wobei die zweite Abdeckungsstruktur (108) im Wesentlichen schlagfest und/oder lichtundurchlässig, druckfest und/oder feuchtigkeitsresistent ist.

8. Anordnung nach Anspruch 1, 2 oder 3, wobei die erste und/oder dritte Abdeckungsstruktur (106, 110) im Wesentlichen wasserdicht, flexibel und/oder weicher als die zweite Abdeckungsstruktur (108) ist.

9. Anordnung nach Anspruch 1, 2 oder 3, wobei die erste, zweite und/oder dritte Abdeckungsstruktur (106, 108, 110) so angeordnet sind, dass sie die Komponente auch gegen elektromagnetische Störfelder schützen.

10. Anordnung nach einem der vorhergehenden Ansprüche, wobei die Anordnung mit einem Schaltelement (206) versehen ist, wie zum Beispiel einem induktiven oder kapazitiven Element, zum Übertragen von Energie auf drahtlose Weise durch mindestens eine Abdeckungsstruktur (106, 108, 110) hindurch.

11. Verfahren zum Schützen einer Komponente (104, 104a, 104b, 104c) mittels eines Textilstoffes, wobei in diesem Verfahren die Komponente mindestens teilweise von einer ersten Abdeckungsstruktur (106) umgeben ist, wobei um die zu schützende Komponente (104) herum, zwischen der ersten Abdeckungsstruktur (106) und der Komponente, auch eine zusätzliche harte, im Wesentlichen nicht biegbare zweite Abdeckungsstruktur (108) angeordnet ist, wobei mindestens ein Teil der geschützten Komponente und/oder mindestens eine weitere Komponente (104a, 104b, 104c), wie zum Beispiel insbesondere eine Textilkomponente und/oder eine flexible Komponente, mindestens teilweise außerhalb der zweiten Abdeckungsstruktur angeordnet ist, **dadurch gekennzeichnet, dass** die erste Abdeckungsstruktur permanent geschlossen ist und aus Textilstoff besteht, wobei die Abdeckungsstruktur durch Laminieren, Kleben mittels Klebstoff, Kleben mittels Klebeband und/oder Vulkanisieren hergestellt wird.

12. Verfahren nach Anspruch 11, wobei um die zu schützende Komponente (104) herum, zwischen der ersten Abdeckungsstruktur (106) und der Komponente, eine weiche dritte Abdeckungsstruktur (110) angeordnet ist.

13. Verfahren nach Anspruch 11, wobei um die zweite Abdeckungsstruktur (108) herum, zwischen der ersten (106) und der zweiten (108) Abdeckungsstruktur, mindestens teilweise ein dritte Abdeckungsstruktur (110) angeordnet ist, die wesentlich weicher als die zweite Abdeckungsstruktur (108) ist.

14. Produkt (300a, 300b), **dadurch gekennzeichnet, dass** es mit einer Anordnung (100) nach einem der Ansprüche 1 bis 10 versehen ist.

15. Produkt nach Anspruch 14, wobei das Produkt (300a) ein Kleidungsstück, wie zum Beispiel ein Mantel, ein Hemd, ein Hut, eine Hose, ein Schuh, eine Socke, ein Handschuh, eine Tasche oder ein Rucksack ist, oder wobei das Produkt (300b) ein Accessoire, eine Fernbedienung, eine Uhr, ein Datenverarbeitungsgerät oder ein die Körperfunktionen oder Parameter des Benutzers messendes Element ist.

## Revendications

1. Agencement (100) pour protéger un composant (104, 104a, 104b, 104c) au moins partiellement au moyen d'un textile, dans lequel agencement, le composant est au moins partiellement entouré par une première structure de recouvrement (106), où autour du composant (104) à protéger, entre la première structure de couverture (106) et ledit composant, on agence au moins partiellement une deuxième structure de recouvrement (108) supplémentaire dure, essentiellement sans flexion, dans lequel au moins une partie du composant protégé et/ou au moins un autre composant (104a, 104b, 104c), tel qu'en particulier un composant textile et/ou un composant flexible, est agencée au moins partiellement à l'extérieur de ladite deuxième structure de recouvrement, **caractérisé en ce que** la première structure de recouvrement est fermée en permanence et réalisée avec un textile, laquelle structure de recouvrement est réalisée par stratification, adhésion, soudage, rubannage et/ou vulcanisation.

2. Agencement selon la revendication 1, dans lequel, autour du composant (104) à protéger, entre la première structure de recouvrement (106) et ledit composant, on agence également au moins partiellement une troisième structure de recouvrement souple (110).

3. Agencement selon la revendication 1, dans lequel, autour de ladite deuxième structure de recouvrement (108), entre les première (106) et deuxième (108) structures de recouvrement, on agence également au moins partiellement une troisième structure de recouvrement (110) qui est essentiellement plus souple que ladite deuxième structure de recouvrement (108).

4. Agencement selon la revendication 1, dans lequel ladite deuxième structure de recouvrement (108) est un renforcement moulé sur la partie supérieure d'une carte de circuit imprimé.

5. Agencement selon l'une quelconque des revendications précédentes, dans lequel le composant (104, 104a, 104b, 104c) à protéger est un composant électronique, tel qu'un câble textile, un capteur de textile, une touche en textile, une antenne en textile, une source de puissance, un écran, une diode électroluminescente, un processeur, un émetteur, un récepteur, une cellule photoélectrique, un amplificateur et/ou un connecteur.

6. Agencement selon la revendication 1, dans lequel la structure de recouvrement (106) est prévue avec au moins une ouverture (204) pour atteindre une interface utilisateur du composant à protéger, telle qu'une touche ou similaire (104c) et/ou pour atteindre un autre élément raccordé au composant et/ou inclus dans le composant.

7. Agencement selon la revendication 1, dans lequel ladite deuxième structure de recouvrement (108) est essentiellement résistante aux chocs et/ou imperméable à la lumière, à la pression et/ou à l'humidité.

8. Agencement selon la revendication 1, 2 ou 3, dans lequel ladite première et/ou troisième structure de recouvrement (106, 110) est essentiellement étanche à l'eau, élastique et/ou plus souple que la deuxième structure de recouvrement (108).

9. Agencement selon la revendication 1, 2 ou 3, dans lequel les première, deuxième et/ou troisième structures de recouvrement (106, 108, 110) sont agencées pour protéger ledit composant également contre une interférence électromagnétique.

10. Agencement selon l'une quelconque des revendications précédentes, dans lequel ledit agencement est prévu avec un élément de commutation (206), tel qu'un élément inductif ou capacitif, pour transférer l'énergie sans fil à travers au moins une structure de recouvrement (106, 108, 110).

11. Procédé pour protéger un composant (104, 104a, 104b, 104c) au moyen de textile, dans lequel procédé, le composant est au moins partiellement entouré par une première structure de recouvrement (106), dans lequel autour du composant (104) à protéger, entre la première structure de recouvrement (106) et ledit composant, on agence également une deuxième structure de recouvrement (108) dure, essentiellement sans flexion, dans lequel au moins une partie du composant protégé et/ou au moins un autre composant (104a, 104b, 104c) tel qu'en particulier un composant textile et/ou un composant flexible, est agencée au moins partiellement à l'extérieur de ladite deuxième structure de recouvrement, **caractérisé en ce que** la première structure de recouvrement est fermée de manière permanente et réalisée à partir de textile, laquelle structure de recouvrement est réalisée par stratification, adhésion, rubannage et/ou vulcanisation.

12. Procédé selon la revendication 11, dans lequel, autour du composant (104) à protéger, entre la première structure de recouvrement (106) et ledit composant, on agence également une troisième structure de recouvrement souple (110).

13. Procédé selon la revendication 11, dans lequel, autour de ladite deuxième structure de recouvrement (108), entre les première (106) et deuxième (108) structures de recouvrement, on agence au moins partiellement une troisième structure de recouvrement (110) qui est essentiellement plus souple que la deuxième structure de recouvrement (108).

14. Produit (300a, 300b) **caractérisé en ce qu'**il est prévu avec un agencement (100) selon l'une quelconque des revendications 1 à 10.

15. Produit selon la revendication 14, dans lequel ledit produit (300a) est un vêtement, tel qu'un manteau, une chemise, un chapeau, une paire de pantalons, une chaussure, une chaussette, un gant, un sac ou un sac à dos ou dans lequel le produit (300b) est un accessoire, une télécommande, un chronomètre, un dispositif de traitement de données ou un élément mesurant les fonctions corporelles ou les paramètres de l'utilisateur.
